# EUROPEAN PATENT APPLICATION

(11) **EP 4 408 136 A1**
(43) Date of publication of application: **31.07.2024**
(21) Application number: 22872430.8
(22) Date of filing: 29.03.2022
(51) Int. Cl.: H05K 3/42

(54) **METHOD OF PRODUCING PRINTED CIRCUIT BOARD, AND METHOD OF FORMING ELECTROCONDUCTIVE UNDERLAYER**

(30) Priority: 24.09.2021 JP 2021156187
(71) Applicant: Elephantech Inc., Tokyo 104-0032 (JP)
(72) Inventor: SHIMIZU, Shinya, Tokyo 104-0032 (JP); NOBORIGUCHI, Shori, Tokyo 104-0032 (JP)
(74) Representative: Strehl Schübel-Hopf & Partner
(86) International application number: PCT/JP2022/015487
(87) International publication number: WO 2023/047671

(57) **Abstract**

An electro-conductive film is formed using an ink-jet method on an inner peripheral surface (inner wall) of a hole that penetrates an insulating substrate from a front surface to a back surface without a defect. When an electro-conductive underlayer is formed on at least an inner wall of a hole 13 that penetrates an insulating substrate 11 from a front surface to a back surface, a filling step of filling an ink 15 in the hole 13 by ejecting electro-conductive ink droplets into the hole 13 using an ink-jet method in a state where the hole 13 is blocked by a closing member 17 from a lower side of the substrate 11, a discharge step of discharging the ink filled in the hole 13 to an outside, and a drying step of drying at least an inner wall ink layer that remains in the inner wall of the hole 13 after the discharge step are executed.

## Description

### Technical Field

The present invention relates to a method of producing a printed circuit board including a via hole and a method of forming an electro-conductive underlayer.

### Background Art

In the related art, a technique is known, in which a layer of a circuit pattern (electro-conductive pattern) is provided on at least two surfaces including a front surface and a back surface of an insulating substrate, a hole that penetrates a substrate is provided for electrical conductivity between both of the layers, and a conductor is embedded in the hole or an electro-conductive film is formed on an inner wall of the hole. In general, the hole for the electrical conduction between the layers is called a via hole (or simply a via) or a through-hole.

For example, PTL 1 discloses a technique in which while keeping one surface side of a base member (substrate) where a desired through-hole is formed at a low pressure, a desired circuit pattern is formed on the base member with a screen printing method using an electro-conductive ink and concurrently the electro-conductive ink is sucked into an inner surface of the through-hole with a vacuum suction force to execute a through-hole conduction process, and subsequently the base member is reversed to execute the formation of the circuit pattern and the through-hole conduction process using the same method as described above. In addition, PTL 1 also discloses that a thick plating process is executed on the circuit pattern using means such as electrolytic plating or electroless chemical plating.

PTL 2 discloses a technique in which, when an electro-conductive film is provided on an inner peripheral surfaces of a through-hole provided in an insulating sheet (for example, a green sheet), the insulating sheet is disposed, through an air-permeable sheet such as paper, on an insulating sheet suction plate where a suction hole is provided on the entire surface irrespective of a pattern of the through-hole of the insulating sheet such that, while executing screen printing using an electro-conductive ink through a mask covering the insulating sheet, ink is sucked by vacuum onto the inner peripheral surface of the through-hole from the insulating sheet suction plate to form a through-hole. The use of the air-permeable sheet prevents the ink from entering a negative pressure chamber that is formed by the suction hole of the insulating sheet suction plate or a housing, and the cleaning of the suction plate or the housing is unnecessary or the number of times of cleaning can be reduced.

PTL 3 discloses a technique in which a backing tape is attached to a ceramic green sheet configuring a ceramic multilayer wiring board to block one opening of a via hole, a mask such as a metal mask or a screen mask is set, an electro-conductive ink (electro-conductive paste) is filled in the via hole by screen printing or the like, and the backing tape is peeled off after curing and solidifying the ink such that the via (for example, the ink) is prevented from being peeled off from the sheet in a via forming step.

PTL 4 discloses a technique in which a silver line is provided on a polyimide film using a droplet ejection method, and when a through-hole that penetrates a polyimide film from one surface to another surface is provided for electrical conduction, droplets of a metal fine particle dispersion are ejected to four locations of a peripheral portion of the hole to apply the metal fine particle dispersion to the entire side surface and the peripheral portion of the hole.

PTL 5 discloses a technique in which, in order to electrically connect a front surface electrode and a back surface electrode of a substrate, a plurality of droplets of an ink including metal fine particles are landed on and applied to an inner wall of a micropore of the substrate to form an ink film.

PTL 6 discloses a technique in which droplets of a metal are ejected to a via hole of a semiconductor substrate using an ink-jet method to form an embedded wiring on an interlayer insulating film.

### Citation List

### Patent Literature

PTL 1: JPS55-6832A
PTL 2: JP2001-111236A
PTL 3: JP2001-111221 A
PTL 4: JP2003-318542A
PTL 5: JP2012-129251A
PTL 6: JP2003-243327A

### Summary of Invention

### Technical Problem

In the techniques of the related art described in PTLs 1 and 2, the electro-conductive ink that is applied to the front surface side of the substrate by screen printing is sucked by vacuum from the back surface side to provide an electro-conductive film on the inner peripheral surface of the hole (through-hole) of the substrate. In addition, in the technique of the related art described in PTL 3, the electro-conductive ink (electro-conductive paste) that is applied by screen printing to the front surface side of the substrate through the mask is filled in the hole (via hole). In all of the techniques of the related art, the screen mask needs to be made for the application of the electro-conductive ink in the screen printing, the initial cost for the screen mask is required, and time and effort is also required for maintenance and repair of the screen mask.

On the other hand, in the techniques of the related art described in PTLs 4 to 6, by ejecting an electro-conductive ink including metal fine particles as the electro-conductive ink using an ink-jet method (droplet ejection method) in the form of droplets, a patterned electro-conductive layer can be formed without using a mask. Accordingly, necessary man-hours can be reduced by using ink-jet printing, and only a small amount of materials is necessary (In the screen printing, the amount of a material to be discarded is relatively large. On the other hand, in the ink-jet printing, the ink is ejected to only a necessary portion, and thus the amount of a material to be discarded is substantially zero).

From this point of view, it can be said that the formation of the electro-conductive film on the via hole inner wall by ink-jet printing is preferable.

Incidentally, the ink-jet printing and the screen printing are different in terms of a printing method, and the ink viscosity values of the electro-conductive inks to be used are generally different. That is, in the screen printing, the ink viscosity is high at 1,000 cps to 200,000 cps. On the other hand, in the ink-jet printing, the ink viscosity is typically low at 1 cps to 40 cps. Therefore, an ink for screen printing and an ink for ink-jet printing have totally different behaviors. Accordingly, the screen printing in the techniques disclosed in PTLs 1 to 3 cannot be replaced with the ink-jet printing as it is. The reason for this is that, when the ink-jet printing is executed on a through-hole using the same method, "ink passing" in which ink droplets pass through the via hole occurs, and the ink layer is not sufficiently attached to the inner wall of the via hole. This ink passing is a phenomenon unique to the ink-jet printing, which cannot occur in the screen printing where the high-viscosity ink is printed in a pressed state.

In addition, even if the ink droplet size increases to execute "front surface film formation" and the ink is sucked from the back surface side, "backside deposition" of the ink occurs and a defect may occur in a back surface wiring pattern. This phenomenon is also a phenomenon that cannot occur in the screen printing where the ink viscosity is high.

In the method of forming the electro-conductive film on the inner peripheral surface of the hole using the leak and spread of the ink from the opening as described in PTL 4, the film thickness of the electro-conductive film is likely to be uneven, and the film thickness uniformity is not sufficient.

In the technique of PTL 5, a high-accuracy droplet ejection control is required to land and apply a plurality of droplets of the ink on and to different positions in a depth direction of the inner wall of the micropore of the substrate. In addition, this technique is the configuration of landing the ink droplets on the inner wall in a scanning direction of an ink-jet head. Therefore, it is not easy to uniformly form the electro-conductive film on the entire inner peripheral surface of the hole of the substrate.

In the technique of PTL 6, the electro-conductive ink used in the ink-jet method is filled in the hole and solidified, and a plating (which is suitable because the resistance value is lower than the ink) cannot be formed on the via hole inner wall by using the ink layer as the underlayer. In addition, in general, when the electro-conductive ink is not thin, cracking occurs due to shrinkage during firing. Therefore, this technique has a problem in that it is not suitable, and the configuration or use thereof is limited.

The present invention has been made under these circumstances, and an object thereof is to provide a method of producing a printed circuit board and a method of forming an electro-conductive underlayer, in which an electro-conductive film can be formed using an ink-jet method on an inner peripheral surface (inner wall) of a hole that penetrates an insulating substrate from a front surface to a back surface without a defect.

### Solution to Problem

A method of producing a printed circuit board according to the present invention includes: a front surface printing step of ejecting electro-conductive ink droplets using an ink-jet method to a front surface of an insulating substrate where a hole is formed from the front surface to a back surface to print a circuit pattern; a filling step of filling the ink in the hole by ejecting the electro-conductive ink droplets into the hole using an ink-jet method in a state where the hole is blocked from a lower side of the substrate in the front surface printing step; a discharge step of discharging the ink filled in the hole to an outside; and a drying step of drying an inner wall ink layer that remains on an inner wall of the hole and an on-substrate ink layer having a circuit pattern shape that is connected to the inner wall ink layer and is formed on the substrate after the discharge step.

An ink is filled in the hole by ejecting ink droplets into the hole using an ink-jet method in a state where the hole is blocked from a lower side of the substrate. Thus, the ink is reliably attached to the entire inner wall of the hole, and the ink remaining in the hole is discharged by discharging the ink to the outside. As a result, a state where an ink layer having a predetermined thickness is substantially uniformly applied to the hole inner wall without unevenness is established.

In the filling step, the ink droplets can be ejected into the hole after blocking the hole using a closing member having a water absorption function. By using the closing member, the temporary filling of the ink into the hole and the subsequent discharge can be realized in a time-series manner.

The closing member is, for example, a porous sheet member, and the discharge step can include a step of waiting until a state where most of the ink filled in the hole is discharged and a part of the ink remains as an ink layer on a wall surface of the hole is established and a step of removing the closing member after the waiting step.

The method of producing a printed circuit board may further include a back surface printing step of reversing the front and back of the substrate after the drying step. After the back surface printing step, the filling step, the discharge step, and the drying step may be executed again. As a result, the reliable electrical connection between the circuit pattern of the back surface and the circuit pattern of the front surface can be obtained through the conductor layer formed in the hole.

The method of producing a printed circuit board may include a step of forming a hole in the substrate before the filling step, or a substrate where a hole is formed in advance may also be used.

The method of producing a printed circuit board may further include a plating step of executing metal plating on the inner wall ink layer and a conductor layer on the substrate that are obtained in the drying step.

A viscosity of the ink is, for example, a value in a range of about 1 cps to 500 cps.

A diameter of the ink droplet is, for example, a value in a range of about 1 µm to 100 µm.

The electro-conductive ink can include metal fine particles of at least one of Ag, Au, Cu, Pd, and Ni, a solution in which the metal is dissolved in an ionic state, or non-metallic conductor fine particles.

An ink filling rate that is a ratio of an amount of the ink ejected into the hole to an inner volume of the hole in the filling step is about 100% to about 200%. It should be noted that, when the filling step, the discharge step, and the drying step are executed again after the back surface printing, the ink filling rate may be about 55% to about 200%.

Another method of producing a printed circuit board according to the present invention includes: a front surface printing step of printing a circuit pattern on a front surface of an insulating substrate; a hole forming step of forming a hole that penetrates front and back surfaces of the substrate on which the circuit pattern is formed; a filling step of filling an ink in the hole by ejecting electro-conductive ink droplets into the hole using an ink-jet method in a state where the front surface side faces downward with respect to the substrate and the hole is blocked from a lower side of the circuit pattern; a discharge step of discharging the ink filled in the hole to an outside; a drying step of drying an inner wall ink layer that remains on an inner wall of the hole and an on-substrate ink layer that is connected to the inner wall ink layer and is formed on the back surface of the substrate after the discharge step; and a plating step of executing metal plating on the inner wall ink layer and a conductor layer on the substrate that are obtained in the drying step.

The method of producing a printed circuit board is different from the above-described production method in that the hole is formed after the front surface printing, but is the same as the above-described production method in that an ink is filled in the hole by ejecting ink droplets into the hole using an ink-jet method in a state where the hole is blocked from a lower side of the substrate. Thus, the ink is reliably attached to the entire inner wall of the hole, and the ink remaining in the hole is discharged by discharging the ink to the outside. As a result, a state where an ink layer having a predetermined thickness is substantially uniformly applied to the hole inner wall without unevenness is established.

In the hole forming step, a laser ablation process may be executed on the circuit pattern. As a result, when the hole formation is executed with a laser, a part of the conductor layer can be removed at the same time. Thus, the processing can be efficiently executed.

According to the present invention, there is provided a method of forming an electro-conductive underlayer on at least an inner wall of a hole of an insulating substrate where the hole is formed from a front surface to a back surface, the method including: a filling step of filling an ink in the hole by ejecting electro-conductive ink droplets into the hole using an ink-jet method in a state where the hole is blocked from a lower side of the substrate; a discharge step of discharging the ink filled in the hole to an outside; and a drying step of drying at least an inner wall ink layer that remains in the inner wall of the hole after the discharge step. "The insulating substrate" in the method of forming an electro-conductive underlayer represents not only a substrate formed of a single material but also a substrate such as a multi-layer substrate where a copper clad laminate or copper and an insulating base material are stacked.

This method of forming an electro-conductive underlayer is applicable to a wide range of methods of forming circuit patterns on the front and back surfaces of the substrate.

### Advantageous Effects of Invention

According to the present invention, it is possible is to provide a method of producing a printed circuit board and a method of forming an electro-conductive underlayer, in which an electro-conductive film can be formed using an ink-jet method on an inner peripheral surface (inner wall) of a hole that penetrates an insulating substrate from a front surface to a back surface without a defect.

### Brief Description of Drawings

[FIG. 1] FIG. 1 is a diagram illustrating steps of a method of producing a printed circuit board according to a first embodiment of the present invention.
[FIG. 2] FIG. 2 is a diagram illustrating steps of a method of producing a printed circuit board according to a first modification example of the first embodiment.
[FIG. 3] FIG. 3 is a graph illustrating a relationship between a resolution (dpi) and an ink filling rate of ink-jet printing.
[FIG. 4] FIG. 4 is a diagram illustrating steps of a method of producing a printed circuit board according to a second embodiment of the present invention.
[FIG. 5] FIG. 5 is a diagram illustrating steps of a method of producing a printed circuit board according to a first modification example of the second embodiment illustrated in FIG. 4.
[FIG. 6] FIG. 6 is a diagram illustrating an example of fining process of a circuit pattern by LA processing in FIG. 5.
[FIG. 7] FIG. 7 is a diagram illustrating steps of a method of producing a printed circuit board according to a second modification example of the second embodiment illustrated in FIG. 4.
[FIG. 8] FIG. 8 is a diagram illustrating steps of a method of producing a printed circuit board according to a third modification example of the second embodiment illustrated in FIG. 4.
[FIG. 9] FIG. 9 is a diagram illustrating evaluation results of printed circuit boards obtained as a result of Examples 1 to 9.

### Description of Embodiments

Hereinafter, an embodiment of the present invention will be described in detail.

In the method of producing a printed circuit board according to the present embodiment, when an ink is applied to an inner wall (inner peripheral surface) of a hole (via hole) that penetrates front and back surfaces of an insulating substrate using ink-jet printing of ejecting ink droplets (fine droplets) of an electro-conductive ink, a closing member (backing plate) having a water absorption function is disposed on a lower side of the substrate to prevent the ink droplets from passing through the hole, and once the ink is stored in the via hole, the ink in the via hole is discharged to the outside. As a result, a state where an ink layer having a predetermined thickness is substantially uniformly applied to the via hole inner wall without unevenness is established. The ink layer formed in the via hole inner wall is dried to form a conductor layer. Further, by executing a metal plating process on the conductor layer as an underlayer, the thickness of the conductor layer increases. As described below in detail, the present embodiment is roughly classified into two embodiments by a timing at which a hole is formed in the insulating substrate.

### <First Embodiment>

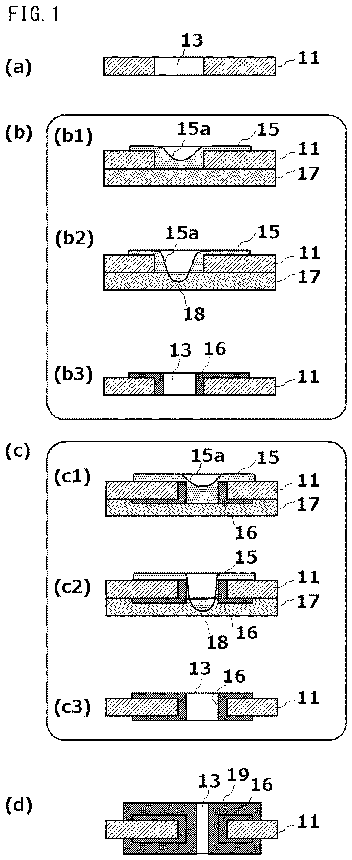

FIG. 1 is a diagram illustrating steps of a method of producing a printed circuit board according to a first embodiment of the present invention. This diagram illustrates only a part of the printed circuit board, that is, only a peripheral region of one via hole for convenience of description. Actually, a plurality of via holes may be present.

In the first embodiment, first, a hole forming step of providing a via hole (hereinafter, simply referred to as "hole") 13 having a predetermined diameter that penetrates an insulating substrate (or a base material) 11 from a front surface to a back surface at a desired position of the insulating substrate 11 is executed (FIG. 1(a)). As means for forming the hole, any existing means such as a drill, a laser, or punching can be used.

The insulating substrate 11 has a film shape or a plate shape and can be configured with an insulating film such as polyimide, polytetrafluoroethylene (PTFE), or a liquid crystal polymer (LCP), or an insulating plate such as glass epoxy (FR-4) or glass composite (CEM3).

The thickness of the substrate 11 is not particularly limited, and a range that can be adopted is about 5 µm to 3 mm and more preferably 25 µm to 50 µm.

A range of the diameter of the hole 13 of the substrate 11 that can be adopted is about 50 µm to 1000 µm, more preferably 100 µm to 300 µm, and typically 200 µm. A depth of the hole 13 is equal to the thickness of the substrate 11 described below.

After the hole forming step, a front surface printing step of ejecting fine droplets (ink droplets) of an electro-conductive ink 15 to the front surface of the insulating substrate 11 where the hole is formed using an ink-jet method to form a circuit pattern (wiring pattern) is executed (FIG. 1(b)). The formation of the conductor layer on the substrate front surface and in the via hole is executed by using, as a method of printing, the Pure Additive (registered trade name) method in which printing is executed only on a portion where a wiring is to be formed with an electro-conductive ink using an ink-jet method without masking the portion instead of a method of using a technique such as a photolithography technique or an etching technique that requires masking (for example, a subtractive method, a semi-additive method, or a modified semi-additive method). This front surface printing step includes a filling step of filling the ink in the hole 13 by ejecting the electro-conductive ink droplets into the hole 13 using an ink-jet method in a state where the hole 13 is blocked from a lower side of the substrate 11 (FIG. 1 (b1)). That is, by using a material that slowly absorbs water as a closing member 17 described below in detail, the ink is temporarily filled in the hole 13 of which a lower end is blocked by the closing member 17. In the present specification, in principle, "filling" represents that the ink is filled in the hole such that the ink is attached to the entire surface of the inner wall of the hole (an ink puddle is formed). The formation of an ink puddle 15a in the hole 13 can be executed together with the printing of the circuit pattern (including a land around the hole) on the surface of the substrate 11.

The electro-conductive ink is an ink including one kind or plural kinds of metal fine particles of at least one of Ag (silver), Au (gold), Cu (copper), Pd (palladium), and Ni (nickel), a solution in which the metal is dissolved in an ionic state, or non-metallic conductor fine particles, or non-metallic conductor fine particles such as C (carbon). A range of the diameter of the ink droplet that can be adopted is about 1 µm to 100 µm, more preferably 10 µm to 30 µm, and typically 20 µm. A range of the viscosity of the ink that can be adopted is about 1 cps to 500 cps, more preferably about 2 cps to 30 cps, and typically 4 cps.

Assuming that the ink puddle 15a is formed in the hole 13, the closing member 17 having water absorption properties is disposed on the lower side of the substrate 11. The closing member 17 is a film-shaped or plate-shaped member formed of a porous material, and is typically an air-permeable sheet member (or a porous sheet member) having air permeability. For example, paper, a porous resin plate, fabric, or non-woven fabric may be used. From the viewpoint of cost, paper is suitable. A range of a pore diameter of the air-permeable sheet member that can be adopted is about 1 µm to 50 µm, more preferably 5 µm to 10 µm, and typically 10 µm. The pore shape of the closing member is not limited to a circular shape. Therefore, in this case, the pore diameter corresponds to a gap width.

In the present embodiment, it is preferable that a basic relationship between the hole diameter of the substrate, the ink droplet diameter, and the pore diameter of the closing member satisfies the hole diameter of the substrate > the ink droplet diameter > the pore diameter of the closing member.

Regarding the filling of the ink in the hole 13, when the water absorption ability of the closing member 17 is not sufficient, the water absorption capacity of the closing member 17 is substantially full while the ink is filling in the hole 13, and there may be a situation in which the discharge does not progress well even after a certain period of time from the filling. In addition, when the water absorption ability of the closing member 17 is excessive, there may be a situation in which an enormous amount of time is required until the ink is completely filled in the hole 13. From this viewpoint, it is desirable that an appropriate relationship is selected as a relationship (condition) between the water absorption ability of the closing member 17 and the amount of the ink ejected per unit time and unit area.

More specifically, it is considered that the water absorption ability of the closing member 17 relates to a water absorption speed and the water absorption capacity of the closing member 17. When the pore diameter of the closing member 17 changes, the most affected factor is the water absorption speed. When the water absorption speed changes, the following situation is expected. That is, when the water absorption speed is sufficiently fast, there is a possibility that the ink filling may not occur. One case where this situation occurs is that a relationship of the ink droplet diameter < the pore diameter of the closing member is satisfied. Conversely, when the water absorption speed is slow, for example, when a plate that is not porous is used as the closing member, it is considered that an excess amount of ink remains in the hole for a long period of time such that the fixing of the ink to the wall surface is inhibited by the surface tension of the ink remaining in the bottom portion.

The front surface printing step also includes a discharge step of discharging the ink filled in the hole 13 to the outside from the hole 13 (FIG. 1(b2)).

Next, as the time elapses, the closing member 17 absorbs the ink, and most of the ink in the hole 13 is discharged from the hole 13. However, the ink layer attached to the inner wall of the hole 13 remains without being discharged. It should be noted that, in FIG. 1(b2), the shape or size of a region of an infiltration portion 18 formed by the closing member 17 absorbing the ink is schematically illustrated simply for convenience of description. Actually, the shape or size of the region of the infiltration portion 18 may change depending on the capacity of the ink puddle 15a in the hole 13 and the material, composition, thickness, and the like of the closing member 17.

The front surface printing step also includes a drying step of drying an ink layer (inner wall ink layer) that remains on the inner wall of the hole 13 and an on-substrate ink layer having a circuit pattern shape that is connected to the inner wall ink layer and is formed on the substrate after discharging the ink from the hole 13 (FIG. 1(b3). The film thickness of the electro-conductive layer (electro-conductive film) obtained in the drying step is 100 nm to 20 µm and more preferably 500 nm to 2 µm.

That is, after waiting for a predetermined period of time from the ink-jet printing on the front surface of the substrate 11, the closing member 17 is removed, and the drying step is executed on the circuit pattern and the land on the front surface of the substrate 11 and the ink layer of the inner wall of the hole 13 connected to the land. As a result, a conductor layer 16 is formed on the front surface and in the via hole. The drying step includes one or a plurality of steps among a blowing process and a heating process.

After the front surface printing step, a back surface printing step is executed (FIG. 1(c)).

In the back surface printing step, the front and back of the substrate 11 obtained in FIG. 1(b3) where the conductor layer 16 is formed on the front surface and in the via hole is reversed (vertically flips), and each of the printing step, the ink discharge step, and the drying step is executed as described above.

That is, in the back surface printing step, fine droplets of the electro-conductive ink 15 are ejected to the back surface using an ink-jet method, the circuit pattern is printed on the back surface, and the ink puddle 15a is formed in the land around the hole and in the hole (FIG. 1(c1)). It should be noted that "back surface" described herein refers to a surface opposite to the front surface of the substrate 11 of FIG. 1(b) and is positioned on the upper surface side in FIG. 1(c) after reversing the front and back of the substrate 11.

Assuming that the ink puddle 15a is formed in the hole 13, the closing member 17 having water absorption properties is disposed on the lower side of the substrate 11 (FIG. 1(c1). Incidentally, the ink is filled in the hole 13 of which the lower end is blocked by the closing member 17 using an ink-jet method. Next, as the time elapses, the closing member 17 absorbs the ink, and most of the ink in the hole 13 is discharged from the hole 13 (FIG. 1(c2). After waiting for a predetermined period of time from the ink-jet printing on the back surface of the substrate 11, the closing member 17 is removed, and the drying step is executed on the circuit pattern and the land on the back surface of the substrate 11 and the ink layer of the inner wall of the hole 13 connected to the land. As a result, a conductor layer 16 is formed on the back surface and in the via hole (FIG. 1(c3)).

In principle, the conductor layer 16 is already formed on the inner wall of the hole 13 in the front surface printing step. Therefore, in the back surface printing step, the connection between the conductor layer 16 in the via hole and the land on the back surface is the main object. It should be noted that there is no problem even when the ink layer remains in the back surface printing to overlap the conductor layer 16 on the inner wall of the hole 13 formed in the front surface printing step and the electrical connection between the back surface land the conductor layer 16 will be more assured.

After the back surface printing step, a metal plating step is executed (FIG. 1(d)). In general, as the plating method, electrolytic plating and electroless plating can be executed. In the present embodiment, electroless plating is executed. It should be noted that, in the present invention, the plating step is not essential for various uses. As the plating metal, Cu, Ni, Ag, Au, or the like can be adopted. In the present embodiment, Cu is adopted. The film thickness of the plating layer is about 0.03 µm to 100 µm and more preferably 3 µm to 18 µm. In addition, the resistance value is 0.001 Ω to 10 Ω and more preferably 0.001 Ω to 1 Ω.

This way, by executing the metal plating on the conductor layer 16, as an underlayer, on the circuit patterns and the lands on the front and back surfaces of the substrate 11 formed in the front surface printing step and the back surface printing step and on the inner wall of the via hole, the thickness of the conductor layer 16 increases. As a result, an increase in the mechanical strength of the circuit pattern and the like and a decrease in the electrical resistance of the conductor layer are realized.

This way, in the present embodiment, the appropriate formation of the conductor on the circuit patterns (including the lands) on the front and back surfaces of the substrate 11 and on the inner wall of the hole 13 by ink-jet printing can be realized with little man-hours.

In the ink discharge step of (b2) and (c2) of FIG. 1, the ink in the hole 13 may be forcibly sucked through the closing member 17 by using vacuum suction means for adjusting the pressure of the closing member 17 side of the substrate 11 to a negative pressure. This suction is an essential element for a high-viscosity ink as in the screen printing in the techniques of the related art described in PTLs 1 and 2. However, when a low-viscosity ink is used in the ink-jet printing as in the present embodiment, the suction is not an essential element and can be used simply for accelerating the speed of the ink discharge.

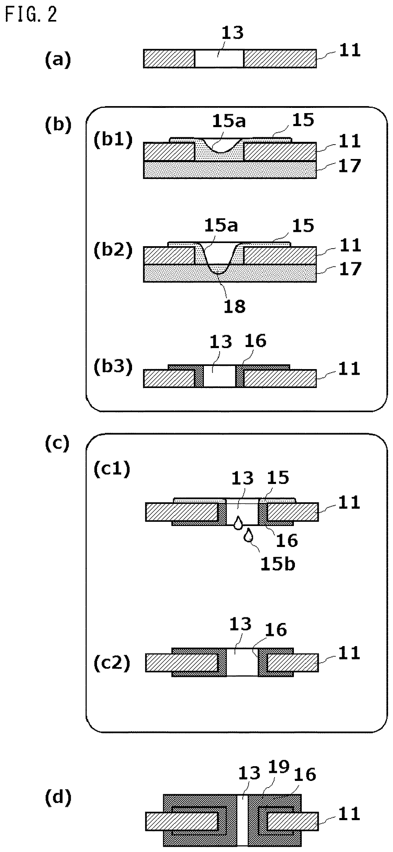

FIG. 2 is a diagram illustrating steps of a method of producing a printed circuit board according to a first modification example of the first embodiment. The same elements as those illustrated in FIG. 1 will be represented by the same reference numerals, and the repeated description thereof will not be repeated.

In the first modification example, in the back surface printing step (FIG. 2 (c1)), the passing of ink droplets 15b ejected into the hole 13 through the lower side of the substrate 11 is allowed during the back surface printing without using the closing member 17 illustrated in FIG. 1. At this time, in order to reduce the amount of the ink droplets passing through the lower side of the substrate 11, the ejection of the ink droplets to a center region of the hole 13 may be skipped. In order to ensure the connection between the conductor of the inner wall of the hole 13 and the peripheral portion (the land portion of the back surface) of the hole 13 of the back surface of the substrate 11, the ejection of the ink droplets to at least the outer peripheral portion of the hole 13 is executed. The other steps of FIG. 2 are as described above with reference to FIG. 1.

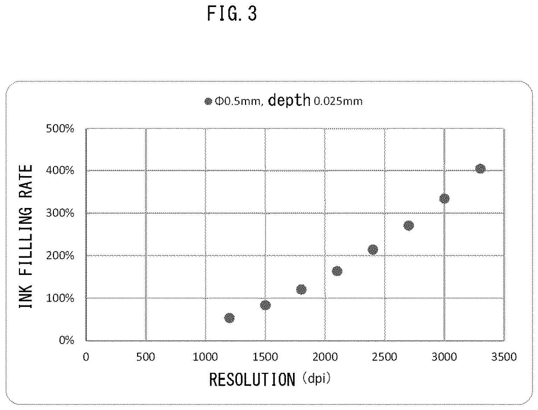

FIG. 3 is a graph illustrating a relationship between a resolution (dpi) and an ink filling rate of ink-jet printing. This data is acquired for Examples where the amount of ink per dot is about 6 pL, the diameter of the hole is 0.5 mm, and the depth of the hole is 0.025 mm. The ink filling rate represents a ratio of the amount of ink ejected into the hole to the inner volume of the hole (via volume). As can be seen from the drawing, a correlation (substantially proportional) between the resolution and the ink filling rate is seen.

In the present embodiment, in principle, the amount of ink ejected into the hole 13 needs to be set to be sufficient with respect to the via volume. The parameters at this time are the amount of ink and the print resolution. When the amount of ink ejected is not sufficient with respect to the via volume, there is a possibility that the fixing of the ink to the inner wall may not occur. Conversely, when the amount of ink is excessively large, error may occur. As an example of the error occurring when the amount of ink is large, an ink puddle may be formed in the hole inner wall to cause cracking during drying. As a result, the plating shape becomes also irregular, and a defect may also occur in that the front and back surfaces are not electrically connected. In the present embodiment, in principle, the ink filling rate is desirably about 100% to about 200%. A desirable range of the print resolution is about 1700 dpi to about 2300 dpi. It should be noted that, however, when the printing step, the filling step, and the drying step are executed on each of the front and back surfaces of the substrate as in the embodiment illustrated in FIG. 1, the ink filling rate may be lower than 100%. The reason for this is that, when the ink is filled in more than half of the lower side in the hole in the filling step from the front side in a thickness direction of the substrate, the substrate is reversed, and the ink is filled in more than new half of the lower side (more than half of the original front side) in the filling step, the steps of the front and back surfaces complement each other such that the conductor layer that is continuous over the entire inner wall of the hole 13 can be obtained. In an actual experiment by the present inventors, it was verified that, even when the thickness of the substrate is relatively large at 125 µm, the ink filling rate of about 55% to about 60% is sufficient in the present embodiment.

### <Second Embodiment>

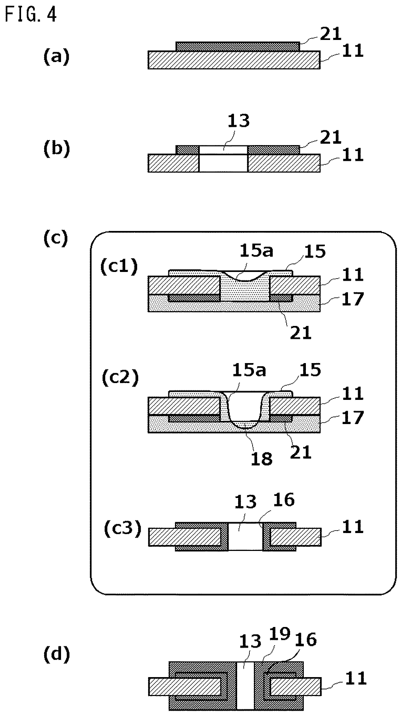

FIG. 4 is a diagram illustrating steps of a method of producing a printed circuit board according to a second embodiment of the present invention. In this embodiment, the hole forming step of the substrate 11 is executed after the front surface printing.

First, a circuit pattern 21 is formed on the front surface of the substrate 11 (FIG. 4(a)). In this case, the circuit pattern 21 does not need to be formed by ink-jet printing. However, in the present embodiment, the circuit pattern 21 is formed by ink-jet printing, and the ink layer is dried to form a front surface conductor layer.

Next, a hole forming process of forming the hole 13 at a desired via position is executed on the substrate 11 obtained in FIG. 4(a) (FIG. 4(b)).

Next, a back surface printing step is executed (FIG. 4(c)).

In the back surface printing step, first, the front and back of the substrate 11 obtained in FIG. 4(b) where the circuit pattern 21 is formed on the front surface is reversed, and each of the back surface printing step (including the ink filling in the hole 13), the ink discharge step, and the drying step is executed. It should be noted that "back surface" described herein refers to a surface opposite to the front surface of the substrate 11 of FIG. 4(b) and is positioned on the upper surface side in FIG. 4(c) after reversing the front and back of the substrate 11.

That is, in the back surface printing step, fine droplets of the electro-conductive ink 15 are ejected to the back surface using an ink-jet method, the circuit pattern is printed on the back surface, and the ink puddle 15a is formed in the land around the hole and in the hole (FIG. 4(c1)).

Assuming that the ink puddle 15a is formed in the hole 13, the closing member 17 having water absorption properties is disposed on the lower side of the substrate 11 (FIG. 4(c1). Thereafter, the ink is filled in the hole 13 of which the lower end is blocked by the closing member 17 using an ink-jet method. Next, as the time elapses, the closing member 17 absorbs the ink, and most of the ink in the hole 13 is discharged from the hole 13 (FIG. 4(c2). After waiting for a predetermined period of time from the ink-jet printing on the back surface of the substrate 11, the closing member 17 is removed, and the drying step is executed on the circuit pattern and the land on the back surface of the substrate 11 and the ink layer of the inner wall of the hole 13 connected to the land. As a result, a conductor layer 16 is formed on the back surface and in the via hole (FIG. 4(c3)).

After the back surface printing step, a metal plating step is executed (FIG. 4(d)). As the metal plating, electroless copper plating is executed in the present embodiment. This way, by executing the electroless plating on the conductor layer, as an underlayer, on the circuit patterns and the lands on the front and back surfaces of the substrate 11 formed in the front surface printing step and the back surface printing step and on the inner wall of the hole, a conductor layer (electroless plating layer) 19 of which the thickness increases is obtained. As a result, an increase in the mechanical strength of the circuit pattern and the like and a decrease in the electrical resistance of the conductor layer are realized.

This way, in the second embodiment, the appropriate formation of the conductor on the circuit patterns (including the lands) on the front and back surfaces of the substrate 11 and on the inner wall of the hole 13 by ink-jet printing can be realized with little man-hours. In particular, the procedure of the front surface printing step can be simplified. A relationship between the resolution (dpi) and the ink filling rate of the ink-jet printing and preferable ranges thereof are the same as those of the first embodiment.

In addition, in the second embodiment, the alignment of the front surface printing is not necessary, and thus a roll-to-roll process is easy. "The roll-to-roll process" refers to a transport configuration in which, when an object on a film or paper is processed, a film prepared from a roll is wound around another roll after being processed. The roll-to-roll process is a process that is adopted to improve the mass productivity as compared to a batch process. In the present embodiment, the printing and the drying can be continuously processed in a batch process. When the hole formation is executed first, land drawing at an ink-jet drawing position needs to be aligned with the formed hole, an accuracy of several tens of micrometers is required, and a transport control needs to be accurately executed. On the other hand, when hole formation is executed after this step, the printing accuracy on the substrate only needs to be less than the film width. Therefore, the accuracy is at least about several millimeters, and the required accuracy of the device is significantly reduced.

In the ink discharge step of FIG. 4(c2), the ink in the hole 13 may be forcibly sucked through the closing member 17 by using vacuum suction means for adjusting the pressure of the closing member 17 side of the substrate 11 to a negative pressure. However, when a low-viscosity ink is used in the ink-jet printing as in the present embodiment, the suction is not an essential element and can be used simply for accelerating the speed of the ink discharge.

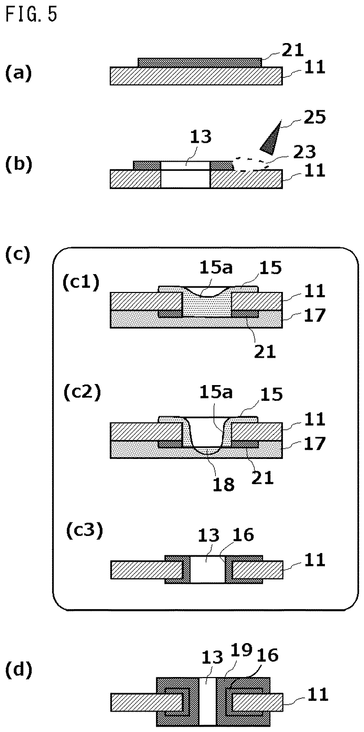

FIG. 5 is a diagram illustrating steps of a method of producing a printed circuit board according to a first modification example of the second embodiment illustrated in FIG. 4. The same elements as those illustrated in FIG. 4 will be represented by the same reference numerals, and the repeated description thereof will not be repeated.

In the first modification example of the second embodiment, laser ablation (LA) processing 25 is executed on the substrate 11 where the circuit pattern 21 is formed. For fining the circuit pattern (including the land) on the substrate 11, the LA processing is executed to remove a part 23 of the conductor layer on the substrate 11. Even in the steps illustrated in FIGS. 1 and 2, the same LA processing can be executed. In the embodiment where the hole is formed after forming the circuit pattern on the substrate 11 as illustrated in FIG. 5, when the hole formation is executed with a laser, a part of the conductor layer can be removed at the same time. Thus, the processing can be efficiently executed.

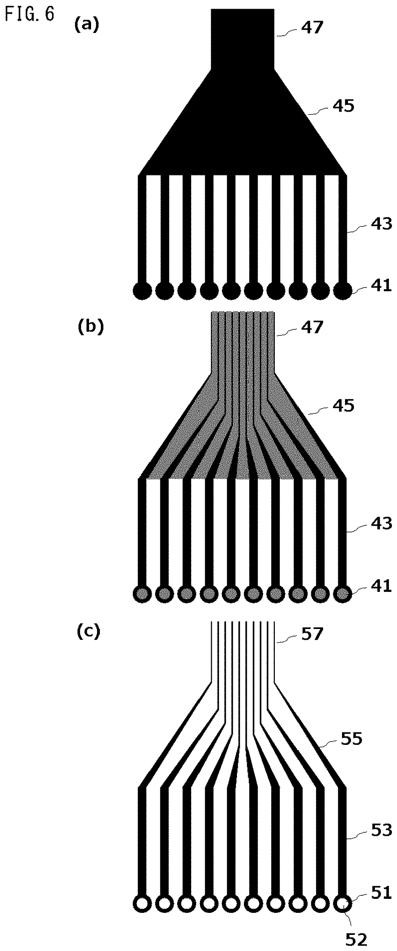

FIG. 6 illustrates an example of the fining process of the circuit pattern by the LA processing. FIG. 6(a) illustrates an example of the conductor layer formed on the front surface (or the back surface) of the substrate by ink-jet printing. This conductor layer includes: a plurality of sequential land portions 41; a low-density conductive pattern portion 43 of which one end is connected to each of the land portions 41; a tapered solid portion 45 that is connected to another end of the low-density conductive pattern portion 43; and a narrow solid portion 47 that is connected to an end portion of the tapered solid portion 45. As illustrated in FIG. 6(b), a gray region of a center portion of the land portion 41 is a hole portion (through-hole) formed by the LA processing, and a gray region in the tapered solid portion 45 and the narrow solid portion 47 is a portion to be removed by the LA processing on the surface of the conductor layer. FIG. 6(c) illustrates a conductor pattern obtained by the LA processing. That is, a high-density conductive pattern portion 57 having a higher density than the low-density conductive pattern portion 43 and a connection conductive pattern portion 55 that connects both of the portions are formed. Even when the low-density conductive pattern portion 43 has a limit density (resolution) obtained by the ink-jet method, the high-density conductive pattern portion 57 having a high density can be provided by the LA processing.

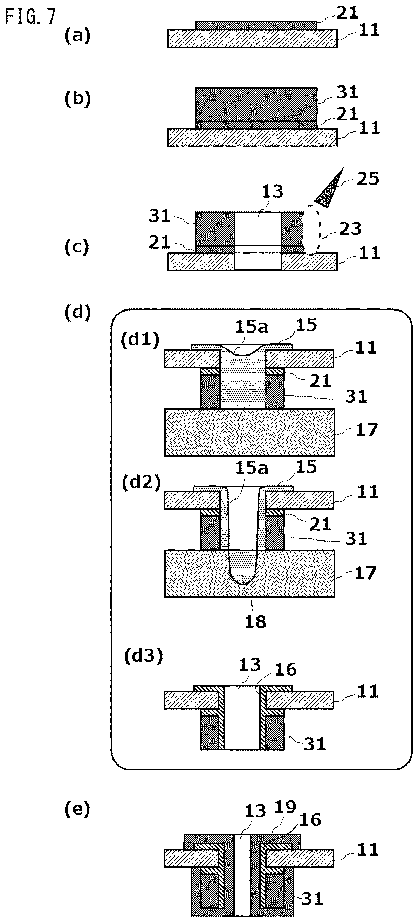

FIG. 7 is a diagram illustrating steps of a method of producing a printed circuit board according to a second modification example of the second embodiment illustrated in FIG. 4.

First, the circuit pattern 21 is formed on the front surface of the substrate 11 (FIG. 7(a)), and by executing the electrolytic plating process on the circuit pattern 21, a circuit pattern 31 that is a conductor layer having a relatively large film thickness is formed (FIG. 7(b)).

Next, by executing the hole forming process on a desired via position of the substrate 11 where the circuit patterns 21 and 31 are formed, the hole 13 is formed (FIG. 17(c)). At this time, optionally, the above-described LA processing 25 can be executed. That is, for fining of the circuit pattern (including the land) on the substrate 11, a part 23 of the conductor layer on the substrate 11 is removed. This process can be executed using a laser used for the hole forming process.

Next, a back surface printing step is executed (FIG. 7(d)).

In the back surface printing step, first, the front and back of the substrate 11 obtained in FIG. 7(c) where the circuit patterns 21 and 31 are formed on the front surface is reversed, and each of the back surface printing step (including the ink filling in the hole 13), the ink discharge step, and the drying step is executed. It should be noted that "back surface" described herein refers to a surface opposite to the front surface of the substrate 11 of FIG. 7(b) and is positioned on the upper surface side in FIG. 7(c) after reversing the front and back of the substrate 11.

That is, in the back surface printing step, fine droplets of the electro-conductive ink 15 are ejected to the back surface using an ink-jet method, the circuit pattern is printed on the back surface, and the ink puddle 15a is formed in the land around the hole and in the hole (FIG. 7(d1)).

Assuming that the ink puddle 15a is formed in the hole 13, the closing member 17 having water absorption properties is disposed on the lower side of the substrate 11 (FIG. 7(d1). Thereafter, the ink is filled in the hole 13 of which the lower end is blocked by the closing member 17 using an ink-jet method. Next, as the time elapses, the closing member 17 absorbs the ink, and most of the ink in the hole 13 is discharged from the hole 13 (FIG. 7(d2). After waiting for a predetermined period of time from the ink-jet printing on the back surface of the substrate 11, the closing member 17 is removed, and the drying step is executed on the circuit pattern and the land on the back surface of the substrate 11 and the ink layer of the inner wall of the hole 13 connected to the land. As a result, a conductor layer 16 is formed on the back surface and in the via hole (FIG. 7(d3)).

After the back surface printing step, a metal plating step is executed (FIG. 7(e)). In this example, as the metal plating, electroless copper plating is executed. This way, by executing the electroless plating on the conductor layer 16, as an underlayer, on the circuit patterns and the lands on the front and back surfaces of the substrate 11 formed in the front surface printing step and the back surface printing step and on the inner wall of the hole, a conductor layer (electroless plating layer) 19 of which the thickness increases is obtained. As a result, an increase in the mechanical strength of the circuit pattern and the like and a decrease in the electrical resistance of the conductor layer are realized.

In the second modification example, as described above, the alignment of the front surface printing is not necessary, and thus a roll-to-roll process is easy.

In the ink discharge step of FIG. 7(d2), the ink in the hole 13 may be forcibly sucked through the closing member 17 by using vacuum suction means for adjusting the pressure of the closing member 17 side of the substrate 11 to a negative pressure. However, when a low-viscosity ink is used in the ink-jet printing as in the present embodiment, the suction is not an essential element and can be used simply for accelerating the speed of the ink discharge.

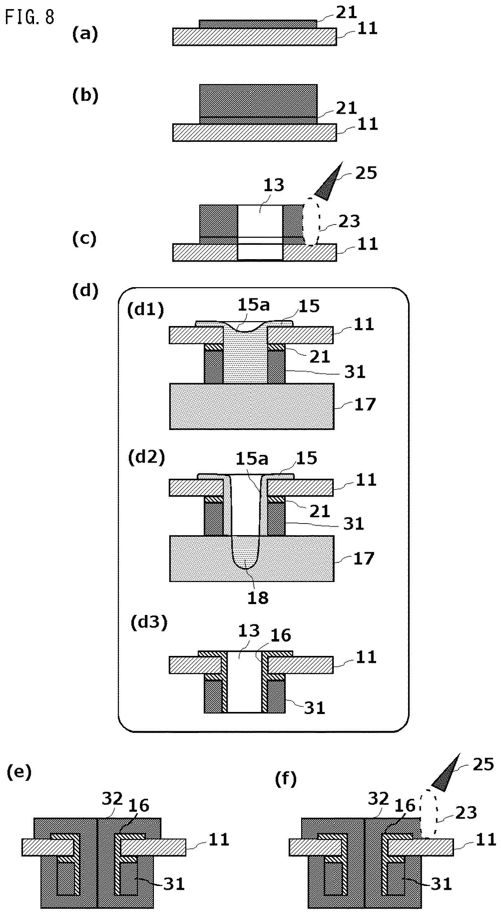

FIG. 8 is a diagram illustrating steps of a method of producing a printed circuit board according to a third modification example of the second embodiment illustrated in FIG. 4. The third modification example is similar to the second modification example illustrated in FIG. 7, the description of the same steps as those of the second modification example will not be repeated, and only different steps will be described in detail.

The steps of Fig. 8(a) to Fig. 8(d) are the same as the steps of Fig. 7(a) to Fig. 7(d). In the third modification example, electrolytic plating is executed instead of electroless plating after the step of Fig. 8(d) (Fig. 8(e)). As a result, a conductor layer (electrolytic plating layer) 32 having a larger film thickness than that obtained by electroless plating can be obtained. In this case, depending on a condition, the entire inside of the hole 13 is embedded with the electrolytic plating layer to enter a solid state. This condition is substantially "the via hole diameter < (the plating film thickness × 2)".

In the electrolytic plating, an increase in film thickness and a control of the film thickness can be executed in a shorter period of time as compared to the electroless plating.

Hereinafter, specific examples will be described.

### <Example 1>

In Example 1, various parameters in the first embodiment were limited to predetermined values (or objects or methods).

As the kind of the insulating substrate (base material), polyimide was used. More specifically, a polyimide film having a thickness of 25 µm on which coating or the like was not executed was used as a base film.

As a hole forming method, laser processing was used. That is, a through-hole was formed using a laser beam machine having a wavelength of 355 nm and a laser spot diameter of 20 µm. The hole diameter (diameter) of the substrate was 200 µm.

As the kind of the electro-conductive ink, an Ag nano-ink was used. Specifically, silver (Ag) having an average particle size of 30 nm was used, and a silver nanoparticle ink for ink-jet including water as a main solvent where the viscosity was 5 cps and the silver nanoparticle content was 15% by weight was used.

As means for discharging the ink, plain paper, here, non-coated paper including pulp having a basis weight of about 64.0 g/m² as a main component was used.

As a method of front surface printing, an ink-jet method was used. That is, the plain paper was laid on the back surface of the substrate, and the ink was ejected to the substrate using an ink-jet method at a ratio of 21 mL per square meter of the coating region. The ink filling rate was 174%.

As a method of front surface drying, the ink layer was dried for 30 minutes using an infrared (IR) heater to form a silver nanoparticle layer (first electro-conductive layer) having an average thickness of 1 µm on the substrate.

As a method of back surface printing, the ink was ejected using an ink-jet method as in the front surface printing.

As a method of back surface drying, the ink layer was dried using the same method as that of the front surface drying to form a second electro-conductive layer.

As a plating method, electroless copper plating was adopted. Specifically, the base film where the silver nanoparticle layers were formed was cleaned using a weak alkaline cleaner solution at room temperature for 1 minute. Next, pre-dipping of an electroless copper plating solution was executed without passing through a step such as palladium catalyst addition, and electroless copper plating was executed at a liquid temperature of 65°C for 50 minutes using an electroless copper plating solution including copper, alkali, and formaldehyde as main components. Next, the base film was dipped in a discoloration preventing agent at room temperature and was dried.

### <Examples 2 to 6>

In Examples 2 to 6, the same production steps as those of Example 1 were adopted, except that, in the production steps of Example 1, the hole diameter of the substrate was changed to five kinds including 100 µm, 150 µm, 300 µm, 500 µm, and 1000 µm, respectively.

### <Examples 7 to 9>

In Examples 7 to 9, the same production steps as those of Example 1 were adopted, except that, in the production steps of Example 1, the thickness of the polyimide film as the base film that was the insulating substrate (base material) was changed to three kinds including 50 µm, 75 µm, and 125 µm, respectively, and the ink filling rate was changed to 145%, 97%, and 58%, respectively.

### <Results of Examples 1 to 6>

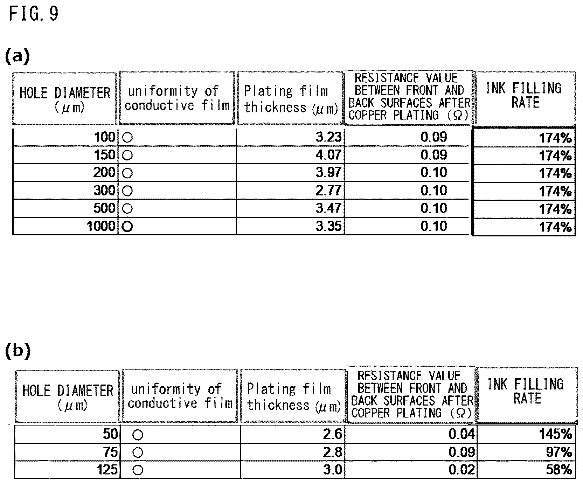

Fig. 9(a) illustrates evaluation results of printed circuit boards obtained as a result of Examples 1 to 6. In this evaluation, a cross-section of the printed circuit board after copper plating was observed using an electron microscope at about 1000-fold. A case where the vertical connection between the electro-conductive layers was verified was represented by ∘ (all of Examples 1 to 6 were represented by o). Copper plating film thicknesses at three positions were measured at the same time, and the average value was described. Further, resistance values between the front and back surfaces at five points were measured, the average value was described, and the applied ink filling rate was also described.

### <Results of Examples 7 to 9>

Fig. 9(b) illustrates evaluation results of printed circuit boards obtained as a result of Examples 7 to 9. In this evaluation, a cross-section of the printed circuit board after copper plating was observed using an electron microscope at about 1000-fold. A case where the vertical connection between the electro-conductive layers was verified was represented by o (all of Examples 7 to 9 were represented by o). Copper plating film thicknesses at three positions were measured at the same time, and the average value was described. Further, resistance values between the front and back surfaces were measured, the average value was described, and the applied ink filling rate was also described.

### <Other Modification Examples>

Hereinabove, the conductor layer is formed in the via hole is executed by using, as a method of producing a printed circuit board, a method of printing a metal only on a portion where a wiring is to be formed without masking the portion instead of a method of using a technique such as a photolithography technique or an etching technique that requires masking (for example, a subtractive method, a semi-additive method, or a modified semi-additive method). The above-described method of forming an electro-conductive underlayer can also be used for some steps of another method requiring masking.

For example, in the subtractive method, a hole that penetrates the front and back of an insulating substrate where copper foil is provided on both surfaces is formed, and subsequently an electro-conductive underlayer is formed on not only an inner wall of the hole but also a land around the hole by electroless plating or the like. That is, in the formation of the electro-conductive film on the inner wall of the hole and the like, a plating catalyst is adsorbed on the entire surface, a copper film is formed by electroless plating on the plating catalyst as an underlayer, and electrolytic plating is executed on the copper film as an electro-conductive underlayer such that the thickness of the copper film increases. Instead of the electroless plating or the like, the method of forming an electro-conductive underlayer using the ink-jet printing can be adopted. As a result, a wet process of the electroless plating or the like where time and effort is high and the cost is high can be reduced.

In the semi-additive method, a hole that penetrates the front and back of an insulating substrate is formed, and subsequently an electro-conductive underlayer is formed on not only an inner wall of the hole but also a land around the hole mainly by electroless plating. That is, in the formation of the electro-conductive film on the inner wall of the hole and the like, a plating catalyst is adsorbed on the entire surface, a copper film is formed by electroless plating on the plating catalyst as an underlayer, and electrolytic plating is executed on the copper film as an electro-conductive underlayer such that the thickness of the copper film increases. Instead of the electroless plating or the like, the method of forming an electro-conductive underlayer using the ink-jet printing can be adopted. As a result, a wet process of the electroless plating or the like where time and effort is high and the cost is high can be reduced.

In the modified semi-additive method, a hole that penetrates the front and back of an insulating substrate where a copper film is attached to both surfaces is formed, a carbon electro-conductive film is formed on an inner wall of the hole mainly using a carbon-based electro-conductive material adsorbed on only a resin portion called a black hole, and electrolytic plating is executed on the carbon electro-conductive film as an electro-conductive layer such that the thickness of the copper film increases. Instead of the black hole or the like, the method of forming an electro-conductive underlayer using the ink-jet printing can be adopted. As a result, a wet process of the black hole or the like where time and effort is high and the cost is high can be reduced.

In addition, even in these methods, optionally, electroless plating or electrolytic plating following the drying step after back surface printing described above can be executed.

In addition, various changes and modifications can be made in a range not departing from the scope of the claims of the present invention.

### Reference Signs List

- 11:: insulating substrate
- 13:: hole (via hole)
- 15:: electro-conductive ink
- 15a:: ink puddle
- 15b:: ink droplet
- 16:: conductor layer
- 17:: closing member
- 18:: infiltration portion
- 19:: conductor layer (electroless plating layer)
- 21:: circuit pattern
- 23:: part
- 25:: laser ablation (LA) processing
- 31:: circuit pattern
- 41:: land portion
- 43:: low-density conductive pattern portion
- 45:: tapered solid portion
- 47:: narrow solid portion
- 55:: connection conductive pattern portion
- 57:: high-density conductive pattern portion

## Claims

1. A method of producing a printed circuit board, the method comprising:
a front surface printing step of ejecting electro-conductive ink droplets using an ink-jet method to a front surface of an insulating substrate where a hole is formed from the front surface to a back surface to print a circuit pattern;
a filling step of filling the ink in the hole by ejecting the electro-conductive ink droplets into the hole using an ink-jet method in a state where the hole is blocked from a lower side of the substrate in the front surface printing step;
a discharge step of discharging the ink filled in the hole to an outside; and
a drying step of drying an inner wall ink layer that remains on an inner wall of the hole and an on-substrate ink layer having a circuit pattern shape that is connected to the inner wall ink layer and is formed on the substrate after the discharge step.

2. The method of producing a printed circuit board according to claim 1,
wherein in the filling step, the ink droplets are ejected into the hole after blocking the hole using a closing member having a water absorption function.

3. The method of producing a printed circuit board according to claim 2,
wherein the closing member is a porous sheet member, and
the discharge step includes a step of waiting until a state where most of the ink filled in the hole is discharged and a part of the ink remains as an ink layer on a wall surface of the hole is established and a step of removing the closing member after the waiting step.

4. The method of producing a printed circuit board according to any one of claims 1 to 3, further comprising: a back surface printing step of reversing the front and back of the substrate and printing a circuit pattern on the back surface of the substrate after the drying step,
wherein the filling step, the discharge step, and the drying step are executed again after the back surface printing.

5. The method of producing a printed circuit board according to any one of claims 1 to 4, comprising a step of forming a hole in the substrate before the filling step.

6. The method of producing a printed circuit board according to any one of claims 1 to 5, further comprising a plating step of executing metal plating on the inner wall ink layer and a conductor layer on the substrate that are obtained in the drying step.

7. The method of producing a printed circuit board according to any one of claims 1 to 6,
wherein a viscosity of the ink is a value in a range of about 1 cps to 500 cps.

8. The method of producing a printed circuit board according to any one of claims 1 to 7,
wherein a diameter of the ink droplet is a value in a range of about 1 µm to 100 µm.

9. The method of producing a printed circuit board according to any one of claims 1 to 8,
wherein the electro-conductive ink includes metal fine particles of at least one of Ag, Au, Cu, Pd, and Ni, a solution in which the metal is dissolved in an ionic state, or non-metallic conductor fine particles.

10. The method of producing a printed circuit board according to any one of claims 1 to 9,
wherein an ink filling rate that is a ratio of an amount of the ink ejected into the hole to an inner volume of the hole in the filling step is about 100% to about 200%.

11. The method of producing a printed circuit board according to claim 4,
wherein an ink filling rate that is a ratio of an amount of the ink ejected into the hole to an inner volume of the hole in the filling step is about 55% to about 200%.

12. A method of producing a printed circuit board, the method comprising:
a front surface printing step of printing a circuit pattern on a front surface of an insulating substrate;
a hole forming step of forming a hole that penetrates front and back surfaces of the substrate on which the circuit pattern is formed;
a filling step of filling an ink in the hole by ejecting electro-conductive ink droplets into the hole using an ink-jet method in a state where the front surface side faces downward with respect to the substrate and the hole is blocked from a lower side of the circuit pattern;
a discharge step of discharging the ink filled in the hole to an outside; and
a drying step of drying an inner wall ink layer that remains on an inner wall of the hole and an on-substrate ink layer that is connected to the inner wall ink layer and is formed on the back surface of the substrate after the discharge step.

13. The method of producing a printed circuit board according to claim 12,
wherein in the filling step, the ink droplets are ejected into the hole after blocking the hole using a closing member having a water absorption function.

14. The method of producing a printed circuit board according to claim 13,
wherein the closing member is a porous sheet member, and
the discharge step includes a step of waiting until a state where most of the ink filled in the hole is discharged and a part of the ink remains as an ink layer on a wall surface of the hole is established and a step of removing the closing member after the waiting step.

15. The method of producing a printed circuit board according to any one of claims 12 to 14,
wherein in the hole forming step, a laser ablation process is executed on the circuit pattern.

16. The method of producing a printed circuit board according to any one of claims 12 to 14, further comprising a plating step of executing metal plating on the inner wall ink layer and a conductor layer on the substrate that are obtained in the drying step.

17. The method of producing a printed circuit board according to claim 12, an electrolytic plating step of executing electrolytic plating on the circuit pattern before the hole forming step and after the front surface printing step.

18. The method of producing a printed circuit board according to claim 17,
wherein in the hole forming step, laser ablation processing is executed on the circuit pattern and a conductor layer formed by the electrolytic plating.

19. The method of producing a printed circuit board according to any one of claims 12 to 18, comprising a back surface printing step of printing a circuit pattern on the back surface of the substrate after the hole forming step,
wherein the filling step, the discharge step, and the drying step are executed after the back surface printing.

20. The method of producing a printed circuit board according to claim 19, comprising a step of executing electroless plating following the drying step after the back surface printing step.

21. The method of producing a printed circuit board according to claim 19, comprising a step of executing electrolytic plating following the drying step after the back surface printing step.

22. The method of producing a printed circuit board according to claim 21,
wherein in the hole forming step, laser ablation processing is executed on the circuit pattern on the back surface of the substrate and a conductor layer formed by the electrolytic plating.

23. A method of forming an electro-conductive underlayer on at least an inner wall of a hole of an insulating substrate where the hole is formed from a front surface to a back surface, the method comprising:
a filling step of filling an ink in the hole by ejecting electro-conductive ink droplets into the hole using an ink-jet method in a state where the hole is blocked from a lower side of the substrate;
a discharge step of discharging the ink filled in the hole to an outside; and
a drying step of drying at least an inner wall ink layer that remains in the inner wall of the hole after the discharge step.

24. The method of forming an electro-conductive underlayer according to claim 23,
wherein in the filling step, the ink droplets are ejected into the hole after blocking the hole using a closing member having a water absorption function.

25. The method of forming an electro-conductive underlayer according to claim 24,
wherein the closing member is a porous sheet member, and
the discharge step includes a step of waiting until a state where most of the ink filled in the hole is discharged and a part of the ink remains as an ink layer on a wall surface of the hole is established and a step of removing the closing member after the waiting step.

26. The method of forming an electro-conductive underlayer according to claim 23, comprising a step of executing electroless plating following the drying step.

27. The method of forming an electro-conductive underlayer according to claim 23, comprising a step of executing electrolytic plating following the drying step.
